# EUROPÄISCHE PATENTSCHRIFT

(11) **EP 2 699 705 B1**
(45) Veröffentlichungstag und Bekanntmachung des Hinweises auf die Patenterteilung: **10.04.2019**
(21) Anmeldenummer: 12706510.0
(22) Anmeldetag: 15.02.2012
(51) Int. Cl.: C23C 14/00, C23C 16/30, C23C 14/08, C23C 14/56

(54) **VERFAHREN ZUM ABSCHEIDEN EINES TRANSPARENTEN BARRIERESCHICHTSYSTEMS**
METHOD OF DEPOSITING A TRANSPARENT BARRIER COATING SYSTEM
PROCÉDÉ DE DÉPÔT D'UN SYSTÈME DE REVÊTEMENT DE BARRIÈRE TRANSPARENTE

(30) Priorität: 18.04.2011 DE 102011017404
(43) Veröffentlichungstag der Anmeldung: 26.02.2014
(73) Patentinhaber: Fraunhofer Gesellschaft zur Förderung der angewandten Forschung E.V., 80686 München (DE)
(72) Erfinder: GÜNTHER, Steffen, 01309 Dresden (DE); MEYER, Björn, 01159 Dresden (DE); STRAACH, Steffen, 01187 Dresden (DE); KÜHNEL, Thomas, 01796 Pirna (DE); BUNK, Sebastian, 01217 Dresden (DE); SCHILLER, Nicolas, 01833 Stolpen OT Helmsdorf (DE)
(86) Internationale Anmeldenummer: PCT/EP2012/052537
(87) Internationale Veröffentlichungsnummer: WO 2012/143149

(56) Entgegenhaltungen:
- WO-A2-2005/073427
- DE-C1- 19 548 160
- SCHILLER S ET AL: "PVD coating of plastic webs and sheets with high rates on large areas", SURFACE AND COATINGS TECHNOLOGY, Bd. 125, Nr. 1-3, 28. Februar 2000 (2000-02-28), Seiten 354-360, XP027328847, ELSEVIER, AMSTERDAM [NL] ISSN: 0257-8972, DOI: 10.1016/S0257-8972(99)00613-1 [gefunden am 2000-03-01]

## Beschreibung

Die Erfindung betrifft ein Verfahren zum Abscheiden eines transparenten Schichtsystems mit einer Barrierewirkung gegenüber Wasserdampf und Sauerstoff.

### Stand der Technik

Elektronisch aktive Materialien, die in verschiedensten elektronischen Baugruppen eingesetzt werden, weisen oftmals eine hohe Empfindlichkeit gegenüber Feuchtigkeit und Luftsauerstoff auf. Um diese Materialien zu schützen, ist es bekannt, derartige Baugruppen zu verkapseln. Das geschieht zum einen durch das direkte Abscheiden einer Schutzschicht auf den zu schützenden Materialien bzw. durch das Einhausen der Baugruppen mittels zusätzlicher Bauteile. So werden beispielsweise Solarzellen oftmals mittels Glas vor Feuchtigkeit und anderen äußeren Einflüssen geschützt. Um Gewicht zu sparen und um auch zusätzliche Freiheitsgrade hinsichtlich des Designs zu erreichen, werden zum Verkapseln auch Kunststofffolien verwendet. Solche Kunststofffolien müssen für eine ausreichende Schutzwirkung beschichtet werden. Auf ihnen wird deshalb mindestens eine sogenannte Permeationssperrschicht (im Folgenden auch als Barriereschicht bezeichnet) abgeschieden.

Barriereschichten setzen verschiedenen permeierenden Substanzen teilweise einen sehr unterschiedlichen Widerstand entgegen. Zur Charakterisierung von Barriereschichten wird häufig die Permeation von Sauerstoff (OTR) und Wasserdampf (WVTR) durch die mit der Barriereschicht versehenen Substrate unter definierten Bedingungen herangezogen (WVTR gemäß DIN 53122-2-A; OTR gemäß DIN 53380-3).

Durch das Beschichten mit einer Barriereschicht wird die Permeation durch ein beschichtetes Substrat gegenüber einem unbeschichteten Substrat um einen Faktor verringert, der im einstelligen Bereich liegen oder viele Größenordnungen betragen kann. Häufig werden neben vorgegebenen Barrierewerten auch noch verschiedene andere Zielparameter von einer Barriereschicht erwartet. Beispielhaft stehen hierfür optische, mechanische sowie technologisch-ökonomische Anforderungen. So sollen Barriereschichten oftmals im sichtbaren Spektralbereich oder darüber hinaus nahezu vollständig transparent sein. Werden Barriereschichten in Schichtsystemen eingesetzt, ist es häufig vorteilhaft, wenn Beschichtungsschritte zum Aufbringen einzelner Teile des Schichtsystems miteinander kombinierbar sind.

Zum Herstellen von Barriereschichten werden häufig sogenannte PECVD-Verfahren (plasma enhanced chemical vapor deposition) eingesetzt. Diese können beim Beschichten verschiedenster Substrate für unterschiedliche Schichtmaterialien zum Einsatz gelangen. Es ist beispielsweise bekannt, auf 13 µm PET-Substraten SiO₂- und Si₃N₄-Schichten einer Dicke von 20 bis 30 nm abzuscheiden [A. S. da Silva Sobrinho et al., J. Vac. Sci. Technol. A 16(6), Nov/Dec 1998, p. 3190-3198]. Bei einem Arbeitsdruck von 10 Pa lassen sich auf diese Weise Permeationswerte von WVTR = 0,3 g/m²d und OTR = 0,5 cm³/m²d erreichen.

Beim Abscheiden von SiOₓ für transparente Barriereschichten auf PET Substraten mittels PECVD lässt sich eine Sauerstoffbarriere von OTR = 0,7 cm³/m²d realisieren [R. J. Nelson and H. Chatham, Society of Vacuum Coaters, 34th Annual Technical Conference Proceedings (1991) p. 113-117]. In einer andere Quellen werden zu dieser Technologie für transparente Barriereschichten auf PET-Substraten Permeationswerte in der Größenordnung WVTR = 0,3 g/m²d und OTR = 0,5 cm³/m²d angegeben [M. Izu, B. Dotter, S. R. Ovshinsky, Society of Vacuum Coaters, 36th Annual Technical Conference Proceedings (1993) p. 333-340].

Nachteile der bekannten PECVD-Verfahren bestehen vor allem darin, dass nur relativ geringe Barrierewirkungen erreicht werden. Das macht solche Barriereschichten insbesondere für die Verkapselung elektronischer Produkte uninteressant. Ein weiterer Nachteil besteht in dem hohen Arbeitsdruck, der für eine Durchführung eines solchen Verfahrens erforderlich ist. Soll ein derartiger Beschichtungsschritt in komplexe Produktionsabläufe in Vakuumanlagen integriert werden, wird unter Umständen ein hoher Aufwand für Maßnahmen der Druckentkopplung erforderlich. Eine Kombination mit anderen Beschichtungsprozessen wird aus diesem Grunde zumeist unwirtschaftlich.

Es ist ferner bekannt, Barriereschichten durch Sputtern aufzubringen. Gesputterte Einzelschichten zeigen oft bessere Barriereeigenschaften als PECVD-Schichten. Für gesputtertes AlNO auf PET werden als Permeationswerte beispielsweise WVTR = 0,2 g/m²d und OTR = 1 cm³/m²d angegeben [Thin Solid Films 388 (2001) 78-86]. Daneben sind zahlreiche andere Materialien bekannt, die insbesondere durch reaktives Sputtern zum Herstellen von transparenten Barriereschichten verwendet werden. Die auf diese Weise hergestellten Schichten weisen jedoch ebenfalls zu geringe Barrierewirkungen auf. Ein weiterer Nachteil derartiger Schichten liegt in ihrer geringen mechanischen Belastbarkeit. Schädigungen, die durch technologisch unvermeidbare Beanspruchungen während der Weiterverarbeitung oder der Benutzung auftreten, führen meist zu einer deutlichen Verschlechterung der Barrierewirkung. Das macht gesputterte Einzelschichten für Barriereanwendungen häufig unbrauchbar. Ein weiterer Nachteil gesputterter Schichten besteht in deren hohen Kosten, die durch die geringe Produktivität des Sputterprozesses verursacht werden.

Bei einer weiterentwickelten Ausführungsform des Abscheidens von Barriereschichten mittels Sputtern werden mindestens zwei Barriereschichten und dazwischen eine organisch modifizierte Metallverbindung als Zwischenschicht abgeschieden (WO 2005/073427 A2). Die Zwischenschicht wird dabei erzeugt, indem eine dampfförmige metall-organische Verbindung in eine Arbeitskammer eingelassen und dort einem Magnetronplasma ausgesetzt wird. Mit einer solchen Schicht wird das Wachstum von Schichtdefekten in den Barriereschichten von einer Barriereschicht zur nächsten Barriereschicht unterbunden und somit die Barrierewirkung des Schichtsystems erhöht.

Es ist weiterhin bekannt, Einzelschichten als Barriereschichten aufzudampfen. Mittels solcher PVD-Verfahren können ebenfalls verschiedene Materialien direkt oder reaktiv auf verschiedensten Substraten abgeschieden werden. Für Barriereanwendungen ist beispielsweise die reaktive Bedampfung von PET-Substraten mit Al₂O₃ bekannt [Surface and Coatings Technology 125 (2000) 354-360]. Hierbei werden Permeationswerte von WVTR = 1 g/m²d und OTR = 5 cm³/m²d erreicht. Diese Barrierewirkung ist ebenfalls viel zu gering, um derart beschichtete Materialien als Barriereschichten für elektronische Produkte verwenden zu können. Sie sind häufig mechanisch noch weniger belastbar als gesputterte Einzelschichten. Von Vorteil sind allerdings die sehr hohen Beschichtungsraten, welche mit Verdampfungsprozessen erreicht werden. Diese liegen üblicherweise um den Faktor 100 über denen, welche beim Sputtern erreicht werden.

Es ist ebenso bekannt, beim Abscheiden von Barriereschichten, Magnetronplasmen für eine Plasmapolymerisation einzusetzen (EP 0 815 283 B1); [So Fujimaki, H. Kashiwase, Y. Kokaku, Vacuum 59 (2000) p. 657-664]. Hierbei handelt es sich um PECVD-Prozesse, die direkt durch das Plasma einer Magnetronentladung aufrechterhalten werden. Beispielhaft steht hierfür das Verwenden eines Magnetronplasmas für PECVD-Beschichtung zur Abscheidung von Schichten mit einem Kohlenstoffgerüst, wobei als Precursor CH₄ dient. Derartige Schichten weisen jedoch ebenfalls eine für hohe Anforderungen eine nur ungenügende Barrierewirkung auf.

Weiterhin ist es bekannt, Barriereschichten bzw. Barriereschichtsysteme in mehreren Beschichtungsschritten aufzubringen. Ein Verfahren aus dieser Gattung ist der sogenannte PML(Polymermultilayer)-Prozess (1999 Materials Research Society, p. 247-254); [J. D. Affinito, M. E. Gross, C. A. Coronado, G. L. Graff, E. N. Greenweil and P.M. Martin, Society of Vacuum Coaters, 39th Annual Technical Conference Proceedings (1996) p. 392-397]. Beim PML-Prozess wird mittels Verdampfer ein flüssiger Acrylat-Film auf ein Substrat aufgebracht, der mittels Elektronenstrahltechnik oder UV-Bestrahlung ausgehärtet wird. Dieser Film weist selbst keine besonders hohe Barrierewirkung auf. Anschließend erfolgt eine Beschichtung des ausgehärteten Acrylatfilms mit einer oxidischen Zwischenschicht, auf die wiederum ein Acrylatfilm aufgebracht wird. Diese Vorgehensweise wird bei Bedarf mehrfach wiederholt. Die Permeationswerte eines derart erzeugten Schichtstapels, also einer Kombination einzelner oxidischer Barriereschichten mit Acrylatschichten als Zwischenschichten, liegt unterhalb der Messgrenze von konventionellen Permeationsmessgeräten. Nachteile ergeben sich hierbei vor allem im notwendigen Einsatz aufwendiger Anlagentechnik. Außerdem bildet sich zunächst ein flüssiger Film auf dem Substrat, der ausgehärtet werden muss. Das führt zu einer verstärkten Anlagenverschmutzung, was Wartungszyklen verkürzt. Bei derartigen Beschichtungsprozessen wird die als Barriereschicht fungierende Zwischenschicht meist mittels Magnetronsputtern hergestellt. Von Nachteil ist auch hierbei, dass durch die Verwendung der Sputtertechnologie auf einen vergleichsweise langsamen Prozess zurückgegriffen wird. Dadurch ergeben sich sehr hohe Produktkosten, die aus der geringen Produktivität der verwendeten Technologien herrühren.

Es ist bekannt, dass sich die mechanische Beständigkeit anorganischer Aufdampfschichten verbessern lässt, wenn während des Verdampfens eine organische Modifizierung vorgenommen wird. Dabei erfolgt der Einbau organischer Bestandteile in die sich während des Schichtwachstums ausbildende anorganische Matrix. Offenbar kommt es durch den Einbau dieser weiteren Bestandteile in die anorganische Matrix zu einer Erhöhung der Elastizität der gesamten Schicht, was die Gefahr von Brüchen in der Schicht deutlich reduziert. Stellvertretend, als zumindest für Barriereanwendungen geeignet, sei in diesem Zusammenhang ein Kombinationsprozess genannt, der eine Elektronenstrahlverdampfung von SiOₓ mit dem Einlass von HMDSO kombiniert (DE 195 48 160 C1). Für elektronische Komponenten erforderliche niedrige Permeationsraten lassen sich mit derart hergestellten Schichten allerdings nicht erzielen.

### Aufgabenstellung

Der Erfindung liegt daher das technische Problem zugrunde ein Verfahren zu schaffen, mit welchem die Nachteile aus dem Stand der Technik überwunden werden. Insbesondere soll mit dem Verfahren ein transparentes Barriereschichtsystem mit einer hohen Sperrwirkung gegenüber Sauerstoff und Wasserdampf sowie einer hohen Beschichtungsrate herstellbar sein.

Die Lösung des technischen Problems ergibt sich durch die Gegenstände mit den Merkmalen des Anspruchs 1. Weitere vorteilhafte Ausgestaltungen der Erfindung ergeben sich aus den abhängigen Ansprüchen.

Bei einem erfindungsgemäßen Verfahren zum Herstellen eines transparenten Barriereschichtsystems werden innerhalb einer Vakuumkammer auf einer transparenten Kunststofffolie mindestens zwei transparente Barriereschichten abgeschieden, zwischen denen auch noch eine transparente Zwischenschicht eingebettet wird. Zum Abscheiden der Barriereschichten wird innerhalb der Vakuumkammer Aluminium in einem reaktiven Prozess verdampft, indem während des Verdampfens des Aluminiums gleichzeitig auch noch mindestens ein Reaktivgas, wie beispielsweise Sauerstoff oder Stickstoff, in die Vakuumkammer eingelassen wird. Die Zwischenschicht wird ebenfalls abgeschieden, indem innerhalb der Vakuumkammer Aluminium bei gleichzeitigem Einlass mindestens eines Reaktivgases, wie beispielsweise Sauerstoff oder Stickstoff, reaktiv verdampft wird. Zusätzlich wird beim Abscheiden der Zwischenschicht während des Verdampfens des Aluminiums gleichzeitig auch noch eine gasförmige oder dampfförmige organische Komponente in die Vakuumkammer eingelassen. Somit werden beim Ausbilden der Zwischenschicht neben dem Hauptbestandteil Aluminium auch noch organische Bestandteile während des Schichtaufbaus eingelagert. Die Zwischenschicht ist somit eine Aluminium-haltige Schicht mit organischen Bestandteilen oder mit anderen Worten ausgedrückt, eine organisch modifizierte Aluminium-haltige Schicht. Als organische Komponente, die gasförmig oder dampfförmig in die Vakuumkammer eingelassen wird, sind beispielsweise Precursoren und insbesondere Silizium-haltige Precursoren wie HMDSO, HMDSN oder TEOS geeignet.

Ein mit dem erfindungsgemäßen Verfahren abgeschiedenes transparentes Barriereschichtsystem zeichnet sich durch eine hohe Sperrwirkung gegenüber Wasserdampf und Sauerstoff sowie einer hohen Belastbarkeit bei Biege- und Dehnungsbelastung auf, wobei das Schichtsystem auch noch mit den für das Verdampfen bekannten hohen Beschichtungsraten abgeschieden werden kann. Aufgrund dieser Eigenschaften sind erfindungsgemäß abgeschiedene Barriereschichtsysteme beispielsweise zum Verkapseln von Bauelementen bei der Solarzellenherstellung, von OLEDs oder elektronisch aktiven Materialien geeignet.

Die hohe Sperrwirkung des erfindungsgemäß abgeschiedenen Schichtsystems gegenüber Wasserdampf und Sauerstoff liegt hauptsächlich darin begründet, dass eine organisch modifizierte Aluminium-haltige Schicht einen Wachstumsstopp von Schichtdefekten einer darunter durch reaktives Aluminiumverdampfen abgeschiedenen Barriereschicht bewirkt. Es ist bekannt, dass einmal entstandene Schichtdefekte, die beim reaktiven Verdampfen von Aluminium entstehen, oftmals mit dem Schichtwachstum durch die restliche Schichtdicke hindurch mitwachsen. Die beim erfindungsgemäßen Verfahren zwischen den Barriereschichten abgeschiedene organisch modifizierte Aluminium-haltige Zwischenschicht vermag es, die Schichtdefekte der darunterliegenden Barriereschicht abzudecken, so dass diese keine Fortsetzung beim Aufwachsen der zweiten über der Zwischenschicht liegenden Barriereschicht finden. Dadurch lässt sich mit einem erfindungsgemäß abgeschiedenen Schichtsystem eine hohe Barriere- bzw. Sperrwirkung gegenüber Wasserdampf und Sauerstoff erzielen. Die Sperrwirkung gegenüber Wasserdampf und Sauerstoff lässt sich bis zu einem bestimmten Grad noch weiter erhöhen, wenn Barriereschicht und Zwischenschicht mehrfach abwechselnd nacheinander abgeschieden werden.

Für das Verdampfen des Aluminiums während des Abscheidens einer Barriereschicht oder einer Zwischenschicht können für das Verdampfen bekannte Schiffchenverdampfer oder auch Elektronenstrahlverdampfer verwendet werden. Das Abscheiden von Barriereschicht oder/und Zwischenschicht kann auch durch ein Plasma unterstützt werden, welches den Raum zwischen Aluminiumverdampfer und einem zu beschichtenden Kunststofffoliensubstrat durchdringt. Dies ist erfindungsgemäß beim Abscheiden der Zwischenschicht, weil das Einwirken eines Plasmas auf eine gasförmige oder dampfförmige organische Komponente das Aufspalten dieser Komponente beschleunigt und somit das Einlagern organischer Bestandteile in die Zwischenschicht fördert. Als Plasmen werden hierbei Hohlkathodenplasmen oder Mikrowellenplasmen verwendet.

### Ausführungsbeispiel

Die Erfindung wird nachfolgend anhand eines Ausführungsbeispiels näher erläutert. Bei einer 650 mm breiten und 75 µm dicken Kunststofffolie aus dem Material PET soll die Sperrwirkung gegenüber Wasserdampf erhöht werden. Hierzu wird die Kunststofffolie in drei Versuchsreihen in einer Vakuumkammer mit unterschiedlichen Aluminium-haltigen Schichten bzw. Schichtsystemen beschichtet.

Zum Verdampfen des Aluminiums werden acht bekannte Schiffchenverdampfer verwendet, die unterhalb der zu beschichtenden Kunststofffolie mit gleichmäßigem Abstand über die Breite der Kunststofffolie verteilt angeordnet sind. Das Verdampfen des Aluminiums erfolgt bei allen drei Versuchen mit einer Verdampfungsrate von 2 g/min für jeden Schiffchenverdampfer, wobei die Kunststofffolie jeweils mit einer Bandgeschwindigkeit von 50 m/min über die Schiffchenverdampfer hinwegbewegt wird. Alle Schichten werden plasmaunterstützt abgeschieden. Vier Hohlkatoden, die ebenfalls mit gleichmäßigem Abstand über die Breite der Kunststofffolie verteilt angeordnet sind, erzeugen eine Plasma, welches den Raum zwischen den Schiffchenverdampfern auf der einen Seite und der zu beschichtenden Kunststofffolie auf der anderen Seite durchdringt. Die vier Hohlkathoden werden dabei mit einem elektrischen Strom von jeweils 300 A gespeist.

In einem ersten Versuch soll lediglich eine Barriereschicht durch reaktives Verdampfen von Aluminium auf dem Kunststoffsubstrat abgeschieden werden. Als Reaktivgas wird Sauerstoff verwendet, welches hierbei und auch in den nachfolgenden Versuchen mit jeweils 12,3 slm in die Vakuumkammer einströmt. Bei den genannten Parametern wird eine Aluminiumoxidschicht mit 70 nm Schichtdicke auf der Kunststofffolie abgeschieden. Für diesen Verbund aus Kunststofffolie und Aluminiumoxidschicht wird eine Barrierewirkung gegenüber Wasserdampf (WVTR in [g/m2/d]) von 0,85 gemessen.

Bei einem zweiten Versuch wird zunächst die aus dem ersten Versuch bekannte 70 nm dicke Barriereschicht aus Aluminiumoxid auf die Kunststofffolie aufgetragen. Anschließend wird die mit der Barriereschicht versehene Kunststofffolie ein weiteres Mal durch die Vakuumkammer geführt und eine organisch modifizierte Aluminiumoxidschicht abgeschieden. Hierbei sind die Parameter des Aluminiumverdampfungsprozesses die gleichen wie beim Abscheiden der Barriereschicht. Zusätzlich wird während des Verdampfens neben dem Reaktivgas Sauerstoff auch noch die organische Komponente HMDSO mit 950 sccm in die Vakuumkammer eingelassen. Durch die Einwirkung des Plasmas auf das HMDSO wird dieses in Bestandteile aufgespalten, die in die zweite Aluminiumoxidschicht eingelagert werden. Auf diese Weise entsteht über der Barriereschicht aus Aluminiumoxid nun eine 85 nm dicke Aluminiumoxidschicht mit organischen Bestandteilen oder mit anderen Worten ausgedrückt eine organisch modifizierte Aluminiumoxidschicht. Für den Verbund aus Kunststofffolie, Aluminiumoxidschicht und organisch modifizierter Aluminiumoxidschicht wurde eine Barrierewirkung gegenüber Wasserdampf (WVTR in [g/m2/d]) von ebenfalls 0,85 gemessen. Die Barrierewirkung hat sich somit gegenüber dem ersten Versuch nicht verbessert. Es konnte jedoch gegenüber dem ersten Versuch eine höhere Dehnbelastung auf die beschichtete Kunststofffolie ausgeübt werden, bis Risse im Schichtsystem sichtbar wurden.

Im dritten Versuch wurde gegenüber dem zweiten Versuch erfindungsgemäß noch eine zweite Barriereschicht auf der organisch modifizierten Aluminiumoxidschicht aufgetragen, die mit den gleichen Parametern wie die erste Barriereschicht aus dem ersten und zweiten Versuch abgeschieden wurde. Das Ergebnis des dritten Versuches umfasste dementsprechend eine 75 µm dicke PET-Folie, zwei 70 nm dicke Barriereschichten aus Aluminiumoxid, zwischen denen sich eine 85 nm dicke organisch modifizierte Aluminiumoxidschicht befindet. Für diesen Verbund konnte eine Barrierewirkung gegenüber Wasserdampf (WVTR in [g/m2/d]) von 0,45 gemessen werden. Gegenüber dem ersten und zweiten Versuch wies das aus dem dritten Versuch stammende Schichtsystem eine verbesserte Sperrwirkung gegenüber Wasserdampf auf. Die Belastbarkeit bei einer Dehnungsbeanspruchung war vergleichbar mit der aus dem zweiten Versuch. Das aus dem dritten Versuch nach dem erfindungsgemäßen Verfahren abgeschiedene Barriereschichtsystem weist somit eine hohe Sperrwirkung gegenüber Wasserdampf und auch noch eine gute Belastbarkeit hinsichtlich einer Dehnungsbeanspruchung auf.

An dieser Stelle sei erwähnt, dass die zuvor genannten Werte physikalischer Größen in Bezug auf die reaktive Aluminiumverdampfung nur beispielhaft angeführt sind und das erfindungsgemäße Verfahren nicht beschränken. Für die reaktive Verdampfung des Aluminiums nach dem erfindungsgemäßen Verfahren können auch alle anderen Werte physikalischer Größen angewendet werden, die aus dem Stand der Technik für die reaktive Aluminiumverdampfung bekannt sind.

## Patentansprüche

1. Verfahren zum Herstellen eines transparenten Barriereschichtsystems mit einer Barrierewirkung gegenüber Wasserdampf und Sauerstoff, wobei in einer Vakuumkammer auf einer transparenten Kunststofffolie mindestens zwei transparente Barriereschichten und eine zwischen den beiden Barriereschichten angeordnete transparente Zwischenschicht abgeschieden werden, **dadurch gekennzeichnet, dass** zum Abscheiden der Barriereschichten Aluminium verdampft und gleichzeitig mindestens Sauerstoff und/oder Stickstoff als ein erstes Reaktivgas in die Vakuumkammer eingelassen wird und dass zum Abscheiden der Zwischenschicht Aluminium verdampft und gleichzeitig mindestens Sauerstoff und/oder Stickstoff als ein zweites Reaktivgas und eine gasförmige oder dampfförmige organische Komponente in die Vakuumkammer eingelassen werden, wobei das Abscheiden der Zwischenschicht von einem Hohlkathodenplasma oder Mikrowellenplasma unterstützt wird.

2. Verfahren nach Anspruch 1, **dadurch gekennzeichnet, dass** die Barriereschicht und die zweite Schicht mehrfach im Wechsel abgeschieden werden.

3. Verfahren nach einem der vorhergehenden Ansprüche, **dadurch gekennzeichnet, dass** das Abscheiden der Barriereschicht bei Anwesenheit eines Plasmas in der Vakuumkammer erfolgen.

4. Verfahren nach Anspruch 3, **dadurch gekennzeichnet, dass** ein Hohlkathodenplasma oder ein Mikrowellenplasma als Plasma verwendet wird.

5. Verfahren nach einem der vorhergehenden Ansprüche, **dadurch gekennzeichnet, dass** ein Silizium-haltiger Precursor als gasförmige oder dampfförmige organische Komponente in die Vakuumkammer eingelassen wird.

6. Verfahren nach Anspruch 5, **dadurch gekennzeichnet, dass** HMDSO, HMDSN oder TEOS als Precursor verwendet wird.

## Claims

1. Method for producing a transparent barrier layer system with a barrier effect with respect to water vapour and oxygen, wherein at least two transparent barrier layers and one transparent intermediate layer arranged between the two barrier layers are deposited on a transparent plastic film in a vacuum chamber, **characterized in that**, for the deposition of the barrier layers, aluminium is vaporized and at the same time at least oxygen and/or nitrogen as a first reactive gas is admitted into the vacuum chamber, and **in that**, for the deposition of the intermediate layer, aluminium is vaporized and at the same time at least oxygen and/or nitrogen as a second reactive gas and a gaseous or vaporous organic component are admitted into the vacuum chamber, wherein the deposition of the intermediate layer is assisted by a hollow cathode plasma or microwave plasma.

2. Method according to Claim 1, **characterized in that** the barrier layer and the second layer are alternately deposited multiple times.

3. Method according to one of the preceding claims, **characterized in that** the deposition of the barrier layer is performed in the presence of a plasma in the vacuum chamber.

4. Method according to Claim 3, **characterized in that** a hollow cathode plasma or a microwave plasma is used as the plasma.

5. Method according to one of the preceding claims, **characterized in that** a silicon-containing precursor is admitted into the vacuum chamber as the gaseous or vaporous organic component.

6. Method according to Claim 5, **characterized in that** HMDSO, HMDSN or TEOS is used as the precursor.

## Revendications

1. Procédé de production d'un système de revêtement de barrière transparent avec une action de barrière à l'égard de la vapeur d'eau et de l'oxygène, dans lequel on dépose dans une chambre sous vide, sur un film de matière plastique transparent, au moins deux couches de barrière transparentes et une couche intermédiaire transparente disposée entre les deux couches de barrière, **caractérisé en ce que** pour le dépôt des couches de barrière on vaporise de l'aluminium et simultanément on admet dans la chambre sous vide au moins de l'oxygène et/ou de l'azote comme premier gaz réactif et **en ce que** pour le dépôt de la couche intermédiaire on vaporise de l'aluminium et simultanément on admet dans la chambre sous vide au moins de l'oxygène et/ou de l'azote comme second gaz réactif et un composé organique sous forme de gaz ou de vapeur, dans lequel on renforce le dépôt de la couche intermédiaire au moyen d'un plasma à cathode creuse ou d'un plasma micro-ondes.

2. Procédé selon la revendication 1, **caractérisé en ce que** l'on dépose la couche de barrière et la seconde couche à plusieurs reprises en alternance.

3. Procédé selon l'une quelconque des revendications précédentes, **caractérisé en ce que** l'on effectue le dépôt de la couche de barrière en présence d'un plasma dans la chambre sous vide.

4. Procédé selon la revendication 3, **caractérisé en ce que** l'on utilise comme plasma un plasma à cathode creuse ou un plasma micro-ondes.

5. Procédé selon l'une quelconque des revendications précédentes, **caractérisé en ce que** l'on admet un précurseur contenant du silicium en tant que composé organique sous forme de gaz ou de vapeur dans la chambre sous vide.

6. Procédé selon la revendication 5, **caractérisé en ce que** l'on utilise comme précurseur du HMDSO, HMDSN ou TEOS.
